# EUROPEAN PATENT SPECIFICATION

(11) **EP 4 024 700 B1**
(45) Date of publication and mention of the grant of the patent: **19.08.2026**
(21) Application number: 19943115.6
(22) Date of filing: 30.08.2019
(51) Int. Cl.: H02P 29/024, G01R 31/34, G05B 23/02, H02H 7/08

(54) **POWER CONVERTING DEVICE AND SIGN DIAGNOSTIC METHOD USED IN SAME**
LEISTUNGSWANDLERVORRICHTUNG UND DARIN VERWENDETES VERFAHREN ZUR DIAGNOSE VON ANZEICHEN
CONVERTISSEUR DE PUISSANCE ET PROCÉDÉ DE DIAGNOSTIC DE SIGNE ASSOCIÉ

(43) Date of publication of application: 06.07.2022
(73) Proprietor: HITACHI INDUSTRIAL EQUIPMENT SYSTEMS CO., LTD., Tokyo 101-0022 (JP)
(72) Inventor: OHYA Masato, Tokyo 101-0022 (JP)
(74) Representative: MERH-IP Matias Erny Reichl Hoffmann Patentanwälte PartG mbB
(86) International application number: PCT/JP2019/034113
(87) International publication number: WO 2021/038829

(56) References cited:
- WO-A1-2018/109993
- GB-A- 2 374 147
- JP-A- 2016 156 643
- JP-A- 2016 158 315
- JP-A- 2018 182 786
- US-A1- 2005 007 096
- US-A1- 2019 006 979
- US-A1- 2020 284 690
- US-B1- 6 529 135

## Description

### TECHNICAL FIELD

The present invention relates to a power converting device for diagnosing an abnormality of an electric motor.

### BACKGROUND ART

In technical fields such as an industrial machinery field, a home appliance field, and an automobile field, a power converting device that drives an electric motor is used.

Examples of an electric motor or a load device driven by the electric motor include those incorporated in production lines such as conveyors and those incorporated as part of parts in machine tools, etc., and have a wide variety of applications. Meanwhile, in any application, when an abnormality such as a failure of a drive system including an electric motor or deterioration of a drive performance occurs, the loss is expected to be excessive. Thus, there is a demand to predict those abnormalities before the abnormalities occur.

In response to such demand, a technology for diagnosing an abnormality in the drive system has been proposed. A sign of failure in the drive system appears as mechanical vibration due to damage, eccentricity, dent, etc. of target drive system equipment. There is a technology for capturing this mechanical vibration by a measurement sensor and a diagnosis is performed from an analysis result of sensor information. In addition, since the vibration of the drive system equipment also affects an electrical system, for example, as in WO 2014/156386 A (Patent Document 1), there is a technology for capturing a current or voltage by a measurement sensor, performing similar analysis, and performing a diagnosis. Patent Literature 2 relates to a method and apparatus for monitoring the performance of an electromechanical machine to warn of a malfunction of the machine takes initial simultaneous measurements of a plurality of parameters characterising the electromechanical behaviour of the machine during the normal operation of the machine, where each parameter characterises a different aspect of the electromechanical behaviour of the machine. Patent Literature 3 relates to a current sensor state determination device determines that an abnormality is caused in a current sensor when a sum of phase currents based on current detection values from each of the current sensors in three phases is greater than a first determination value, and determines that no abnormality is caused in the current sensor when the sum of phase currents is equal to or less than the first determination value.

Patent Document 4 discloses an abnormality diagnostic device for a power transmission mechanism that uses a current detector and analysis unit to determine abnormalities in the system. It analyses the current waveform spectrum to identify different levels of abnormalities.

Patent Document 5 discloses a power meter with sensors for non-invasive monitoring of a motor's operation, wherein a processor compares operational feedback against baseline data to determine the motor's wellness and communicates alerts if necessary.

### CITATION LIST

### PATENT DOCUMENT

Patent Document 1: WO 2014/156386 A
Patent Document 2: GB 2 374 147 A
Patent Document 3: US 2019/006979 A1
Patent Document 4: WO 2018/109993 A1
Patent Document 5: US 2005/007096 A1

### SUMMARY OF THE INVENTION

### PROBLEMS TO BE SOLVED BY THE INVENTION

Patent Document 1 describes a calculation method for diagnosing target drive system equipment and describes that an abnormality level is determined based on a calculation result thereof, and the abnormality level is output quantitatively or qualitatively as a determination result thereof.

However, it may not be possible to correctly determine an abnormality level due to a driving condition of the electric motor, for example, a driving state of the electric motor such as during constant speed, acceleration, deceleration, or stop, a speed condition during driving, for example, a speed state of the electric motor such as rated speed range, high speed range, low speed range, or near zero speed, or a disturbance condition, for example, an environmental state of the drive system such as a fluctuation in load characteristic or a malfunction of the measurement sensor.

In Patent Document 1, even when determination of the level of abnormality in the target drive system equipment diagnosis is not correctly performed, a determination result by diagnosis is output. Therefore, when a user changes setting or replaces parts according to the diagnosis result, there is a problem that the production efficiency is lowered.

In view of the above problems, an object of the invention is to provide a power converting device capable of clearly indicating to the user whether or not an abnormality diagnosis is properly performed and a sign diagnostic method used therefor, and to implement appropriate operation and maintenance of the power converting device.

### SOLUTIONS TO PROBLEMS

In view of the above background technology and problems, as an example, the invention is a power converting device according to claim 1.

### EFFECTS OF THE INVENTION

According to the invention, it is possible to provide a power converting device capable of clearly indicating a functional operation status of a target drive system equipment diagnosis and a sign diagnostic method used for the power converting device.

### BRIEF DESCRIPTION OF THE DRAWINGS

Fig. 1 is a configuration block diagram of a power converting device in an embodiment.
Fig. 2 is a configuration block diagram of a sign diagnostic function unit in the embodiment.
Fig. 3 is a diagram illustrating an example of a state transition of a diagnostic state in the embodiment.
Fig. 4 is a diagram illustrating an example of a change of a sign diagnosis result in the embodiment.

### MODE FOR CARRYING OUT THE INVENTION

Hereinafter, a configuration and operation of the power converting device according to an embodiment of the invention will be described with reference to the drawings.

### Embodiment

In the present embodiment, a description will be given of an overall configuration of a control system for driving an AC electric motor and diagnosing a sign of a mechanical abnormality of the AC electric motor, and a power converting device equipped with this control system.

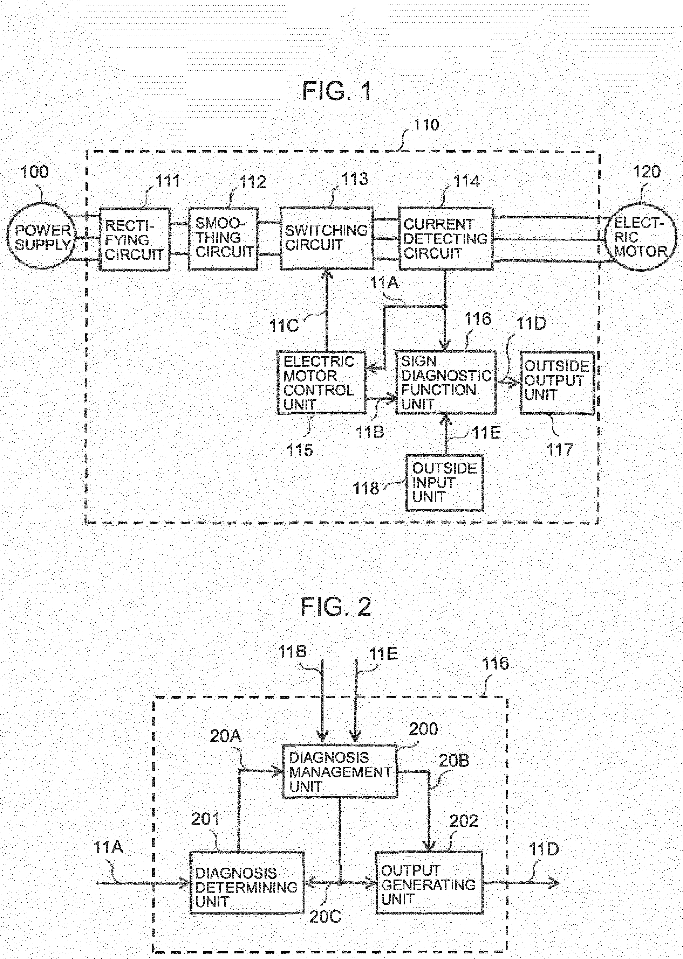

Fig. 1 is a configuration block diagram of the power converting device according to the present embodiment. In Fig. 1, a power converting device 110 that drives a three-phase AC electric motor 120 includes a rectifying circuit 111, a smoothing circuit 112, a switching circuit 113, a current detecting circuit 114, an electric motor control unit 115, a sign diagnostic function unit 116, an outside output unit 117, and an outside input unit 118.

A three-phase AC voltage output from a three-phase AC power supply 100 is rectified by the rectifying circuit 111 and smoothed by the smoothing circuit 112 to generate a DC voltage. Note that a single-phase AC power supply may be used instead of the three-phase AC power supply 100 to rectify and smooth a single-phase AC voltage to generate a DC voltage. Further, the rectifying circuit 111 and the smoothing circuit 112 may be removed to obtain a DC voltage directly from the DC power supply.

The switching circuit 113 inverts a DC voltage into an arbitrary three-phase AC voltage based on a gate drive instruction 11C by combining ON/OFF of a plurality of switching elements, and applies the inverted three-phase AC voltage to the three-phase AC electric motor 120. The switching circuit 113 can be configured by, for example, connecting U-phase, V-phase, and W-phase arms in which two switching elements are connected in series to each other in parallel.

The current detecting circuit 114 detects a three-phase output current of the power converting device 110. Since only two phases are detected and the sum of the three-phase alternating currents is zero, the remaining one phase may be calculated. Note that a shunt resistor may be provided on a positive electrode side or a negative electrode side of the input of the switching circuit 113, and a three-phase output current may be estimated from a current flowing through the shunt resistor.

The electric motor control unit 115 outputs a control state signal 11B and a gate drive instruction 11C. The control state signal 11B includes control information in the electric motor control unit 115. The control information includes a driving state such as forward rotation, reverse rotation, or stop, a speed state such as during acceleration, deceleration, or constant speed, and further, output torque, etc. In addition, for example, the control information further includes a disturbance condition, for example, an environmental state of a drive system such as a fluctuation of a load characteristic or a malfunction of a measurement sensor.

The gate drive instruction 11C estimates a speed of the three-phase AC electric motor 120 using a detected current 11A, and outputs the speed so as to have a desired drive characteristic based on a speed instruction of the three-phase AC electric motor. Note that a position instruction or a torque instruction may be used. instead of the speed instruction. Further, due to the desired drive characteristic, the speed of the three-phase AC electric motor 120 is not necessarily estimated using the detected current 11A.

The sign diagnostic function unit 116 diagnoses a sign of a mechanical abnormality of the three-phase AC electric motor 120 by using the detected current 11A, the control state signal 11B, and an outside input signal 11E input from the outside input unit 118, and outputs an outside output signal 11D, which is a result of the sign diagnosis.

The outside output unit 117 notifies the outside of the power converting device 110 of the result of the sign diagnosis of the mechanical abnormality of the three-phase AC electric motor 120 by the outside output signal 11D.

The outside input unit 118 analyzes the input to the power converting device 110 and outputs information necessary for the sign diagnosis of the mechanical abnormality of the three-phase AC electric motor 120 as the outside input signal 11E.

Next, a configuration of the sign diagnostic function unit 116 will be described. Fig. 2 is a configuration block diagram of the sign diagnostic function unit 116 in the present embodiment.

In Fig. 2, the sign diagnostic function unit 116 includes a diagnosis management unit 200, a diagnosis determining unit 201, and an output generating unit 202, and outputs the outside output signal 11D to the outside output unit 117.

The diagnosis management unit 200 outputs a diagnosis mode signal 20C indicating a state of the sign diagnosis by the control state signal 11B and the outside input signal 11E, and outputs information necessary for generating the outside output signal 11D of the sign diagnosis result as a diagnosis result signal 20B by the control state signal 11B, the outside input signal 11E, and an abnormality determination signal 20A.

The diagnosis determining unit 201 determines the level of the mechanical abnormality of the three-phase AC electric motor 120 based on the detected current 11A. That is, a threshold value of abnormality determination is provided inside, the threshold value is compared with the detected current 11A, and the abnormality determination signal 20A is output. The abnormality determination signal 20A turns ON when the detected current 11A deviates from the threshold value and turns OFF when the detected current 11A is within the threshold value. Further, the threshold value is recalculated according to the input diagnosis mode signal 20C.

The output generating unit 202 outputs the outside output signal 11D from the diagnosis result signal 20B and the diagnosis mode signal 20C as information necessary for the external display by the outside output unit 117.

Hereinafter, a basic operation in the present embodiment will be described. The sign diagnosis result of the mechanical abnormality of the three-phase AC electric motor 120, which is the basis of the present embodiment, includes two elements of an abnormality degree and a diagnostic state. The abnormality degree is set as a four-stage level of not applicable, normal, abnormal sign, and abnormal, which correspond to the diagnosis result signal 20B. The diagnostic state is set as five states of diagnosis invalid, diagnosis being prepared, diagnosis being executed, diagnosis being paused, and diagnosis unsuccessful, which correspond to the diagnosis mode signal 20C.

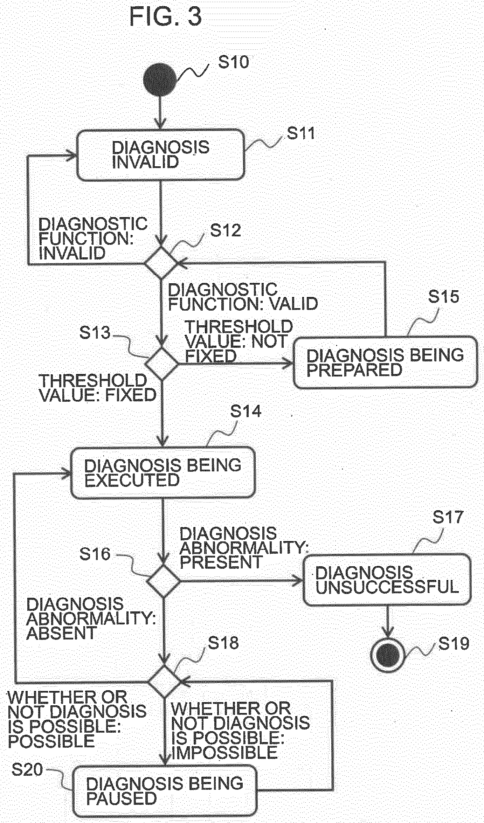

Next, a process of determining the sign diagnosis result will be described. Fig. 3 illustrates an example of a state transition of the diagnostic state in the present embodiment. In Fig. 3, a black circle means a start state, a block dot in a circle means an end state, a square with rounded corners means an actual state, and a square inclined by 45 degrees means a temporary selection state. The temporary selection state is a temporary state for selecting a next state in response to a previous state, and a transition is performed in a direction that meets a next transition condition. In addition, each arrow represents a transition from one state to another state.

Hereinafter, the state transition of the diagnostic state in the present embodiment will be described with reference to Fig. 3. In Fig. 3, at start S10 of the state transition of the diagnostic state, there is a transition from a start state to diagnosis invalid S11. In the state of diagnosis invalid S11, which is an initial state of the state, a condition of whether a function of diagnosing the sign is valid or invalid is first verified (S12). The function of diagnosing the sign is set as the outside input signal 11E from the outside input unit 118, assuming that the user of the power converting device 110 can determine whether or not this function is valid or invalid. The outside input unit 118 may be of any form as long as valid or invalid can be set, and for example, there are an outside input unit such as a touch panel or a toggle switch to which input is directly performed by a person, an outside input unit such as a programmable logic controller to which input is performed by a device machine, etc. When the function for diagnosing the sign is invalid, the state of diagnosis invalid S11 is maintained, and whether the function for diagnosing the sign is valid or invalid is verified at a fixed cycle or a non-fixed cycle.

When the function for diagnosing the sign is valid, a condition of whether the threshold value is fixed or is not fixed is subsequently verified (S13). When the threshold value is fixed, a transition is made to diagnosis being executed S14, and when the threshold value is not fixed, a transition is made to diagnosis being prepared S15. This threshold value is a value that is fixed during diagnosis being prepared and is not recalculated in any other state. Note that to fix the threshold value, the threshold value may be set from the outside input unit 118 or set from a current value of the three-phase AC electric motor 120 driven by the power converting device 110. As an example of setting the threshold value from the current value of the three-phase AC electric motor 120, there is a method of setting a value of about 2 to 3 times a current value of normal driving, which is a value deviating from the current value, as an abnormal value and adopting the value as the threshold value.

In the state of diagnosis being prepared S15, confirmation of validity or invalidity of the function for diagnosing the sign (S12) and confirmation of the condition of whether the threshold value is fixed or is not fixed (S13) are preformed according to a state transition.

In the state of diagnosis being executed S14, it is determined whether or not a diagnosis abnormality occurs (S16). When the diagnosis abnormality occurs, a transition is made to diagnosis unsuccessful S17. When the diagnosis abnormality does not occur, it is determined whether or not a control state is diagnosable (S18). The diagnosis abnormality refers to an abnormality of the diagnostic function. As an example, when hardware, a sensor, a circuit, etc. for acquiring the detected current 11A fail, and the detected current 11A detects a value of zero even though the three-phase AC electric motor 120 is driven by the power converting device 110, it is determined that the value of the detected current is abnormal.

As in the above example, when the value of the detected current 11A is abnormal, the function for diagnosing the sign is valid, and even when the threshold value is fixed, the sign diagnostic function cannot be accurately performed, and thus a transition is made from the sign diagnostic state to the state of diagnosis unsuccessful S17, and this state transition is terminated (S19).

In determination S18 of whether or not the control state is diagnosable, when the control state is diagnosable, a transition is made to the state of diagnosis being executed S14, and when the control state is not diagnosable, a transition is made to the state of diagnosis being paused S20. The case where the control state is not diagnosable as described above includes a control state during acceleration or deceleration of the three-phase AC electric motor 120, a low speed range in the vicinity including zero speed, etc. Further, the case where the load characteristic connected to the three-phase AC electric motor 120 fluctuates and the current pulsates, so that a result of the abnormality determination signal 20A cannot correctly output the abnormality determination is further included. Note that whether or not the control state is diagnosable is determined by the diagnosis management unit 200 using the control state signal 11B.

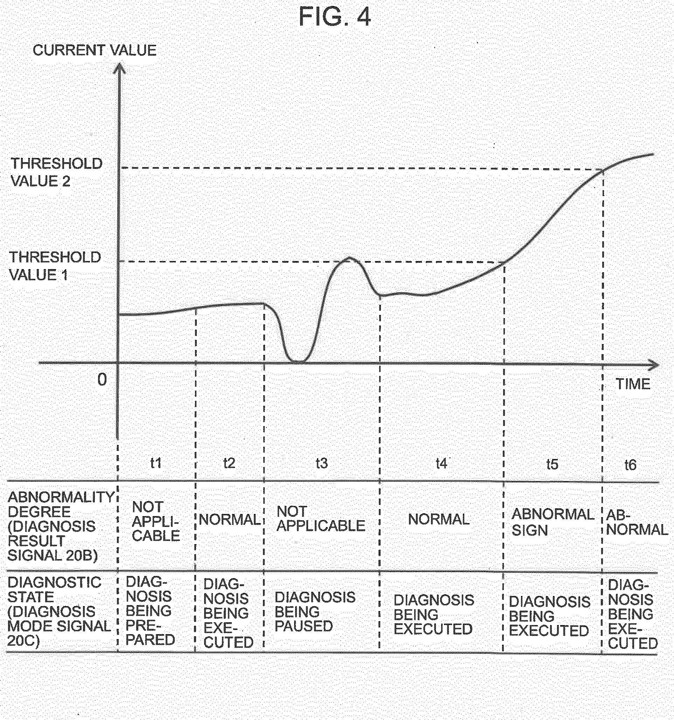

Fig. 4 is an example of a change of a sign diagnosis result in the present embodiment. Fig. 4 illustrates a graph in which a horizontal axis indicates time and a vertical axis indicates current value (detected current 11A), and a part below the graph illustrates an abnormality degree (diagnosis result signal 20B) and a diagnostic state (diagnosis mode signal 20C) corresponding to the graph. Note that t1 to t6 mean time-divided periods, and a process of determining the sign diagnosis result will be described below according to t1 to t6.

In Fig. 4, in the present embodiment, a time when the function for diagnosing the sign is valid is set as the origin. At a time before t1, the function for diagnosing the sign is invalid, and thus the abnormality degree is not applicable and the diagnostic state is diagnosis invalid.

t1 is a period for fixing a threshold value 1 and a threshold value 2, in which the abnormality degree is not applicable, and the diagnostic state is diagnosis being prepared.

t2 is a period in which the threshold value is fixed, the diagnosis abnormality is absent, and the diagnosis is possible. In this period, the abnormality degree is normal, and the diagnostic state is diagnosis being executed. Note that in the present embodiment, about twice a current value during the period t1 is set as the threshold value 1, and about four times the current value is set as the threshold value 2.

t3 is a period in which the three-phase AC electric motor 120 is controlled to decelerate, stop, and accelerate. In this period, the abnormality degree cannot be classified, and thus is not applicable, and the diagnostic state is diagnosis being paused. In t3, there is a time when the current value exceeds the threshold value 1, and thus the abnormality determination signal 20A is turned ON. However, since the diagnostic state is diagnosis being paused, the abnormality is not transmitted to the user.

t4 is similar to t2.

t5 is a period in which the current value increases in the period t4 to exceed the threshold value 1. In this period, the abnormality degree is abnormal sign, and the diagnosis state is diagnosis being executed.

t6 is a period in which the current value further increases from the period t5 and exceeds the threshold value 2. In this period, the abnormality degree is abnormal, and the diagnostic state is diagnosis being executed. The above description is the process of determining the sign diagnosis result.

In addition, in response to determination of the sign diagnosis result, the output generating unit 202 generates the outside output signal llD and notifies the user through the outside output unit 117. As a device for notification, there is no limitation on the form after the outside output unit 117. For example, the sign diagnosis result is displayed as a character string on an LCD screen at all times, or a rotating light, an indicator light, or a buzzer is used for notification only when an abnormality occurs.

By the above operation, in the transmission of the sign diagnosis result of the mechanical abnormality of the three-phase AC electric motor 120, the user is notified of whether the diagnosis is correct or not, so that it becomes possible to provide a power converting device that can clearly indicate whether or not the diagnosis is properly performed.

As described above, according to the present embodiment, in the target drive system equipment diagnosis; it is possible to provide a power converting device capable of not only determining the abnormality level and outputting the determination result thereof but also outputting the state of the function of the target drive system equipment diagnosis together to realize the functional operation status of the target drive system equipment diagnosis in an explicit expression.

Even though the embodiments have been described above, the present invention is not limited to the above-mentioned embodiments, and various modifications are included. Further, the above-described embodiments have been described in detail in order to describe the invention in an easy-to-understand manner, and are not necessarily limited to the one including all the described configurations.

### REFERENCE SIGNS LIST

- 11A: Detected current
- 11B: Control state signal
- 11C: Gate drive instruction
- 11D: Outside output signal
- 11E: Outside input signal
- 20A: Abnormality determination signal
- 20B: Diagnosis result signal
- 20C: Diagnosis mode signal
- 100: Three-phase AC power supply
- 110: Power converting device
- 111: Rectifying circuit
- 112: Smoothing circuit
- 113: Switching circuit
- 114: Current detecting circuit
- 115: Electric motor control unit
- 116: Sign diagnostic function unit
- 117: Outside output unit
- 118: Outside input unit
- 120: Three-phase AC electric motor
- 200: Diagnosis management unit
- 201: Diagnosis determining unit
- 202: Output generating unit

## Claims

1. A power converting device (110) for controlling an AC electric motor (120), the power converting device comprising:
a current detecting circuit (114) for detecting a phase current of the AC electric motor (120); and
a sign diagnostic function unit (116) having a sign diagnostic function for diagnosing a sign of a mechanical abnormality of the AC electric motor (120), wherein the sign diagnostic function unit (116) includes
a diagnosis determining unit (201) for determining a level of a mechanical abnormality of the AC electric motor (120) based on the detected phase current,
a diagnosis management unit (200) for managing an execution state of the sign diagnostic function from a determination result of the diagnosis determining unit (201), a control state of the AC electric motor (120), and an environmental state of a drive system including the AC electric motor (120), and
an output generating unit (202) for generating display information of an execution result of the sign diagnostic function in response to an instruction from the diagnosis management unit (200), and for outputting the display information to an outside of the power converting device (110), wherein
the instruction from the diagnosis management unit (200) is a diagnosis result signal (20B) corresponding to an abnormality degree and a diagnosis mode signal (20C) corresponding to a diagnostic state, wherein
the abnormality degree is a four-stage level among not applicable, normal, abnormal sign, and abnormal, wherein
the diagnostic state is five states of diagnosis invalid, diagnosis being prepared, diagnosis being executed, diagnosis being paused, and diagnosis unsuccessful, wherein
in the state of diagnosis being executed, the sign diagnostic function unit (116) determines whether or not a diagnosis abnormality occurs, and when the diagnosis abnormality occurs, a transition is made from the state of diagnosis being executed to the state of diagnosis unsuccessful, and the state transition is terminated.

2. The power converting device (110) according to claim 1, wherein the diagnosis determining unit (201) has a threshold value for abnormality determination inside, and is configured to compare the threshold value with the phase current to determine a level of an abnormality.

3. A sign diagnostic method for diagnosing a sign of a mechanical abnormality of an AC electric motor (120) in a power converting device (110) for controlling the AC electric motor (120), the method comprising:
detecting a phase current of the AC electric motor (120);
determining a level of a mechanical abnormality of the AC electric motor (120) based on the detected phase current;
generating a diagnosis result signal (20B) corresponding to an abnormality degree and a diagnosis mode signal (20C) corresponding to a diagnostic state from a determination result, a control state of the AC electric motor (120), and an environmental state of a drive system including the AC electric motor (120), wherein
the abnormality degree is a four-stage level among not applicable, normal, abnormal sign, and abnormal, and the diagnostic state is five states of diagnosis invalid, diagnosis being prepared, diagnosis being executed, diagnosis being paused, and diagnosis unsuccessful;
generating display information from the diagnosis result signal (20B) and the diagnosis mode signal (20C); and
outputting the display information to an outside of the power converting device (110), and
determining, in the state of diagnosis being executed, whether or not a diagnosis abnormality occurs, and when the diagnosis abnormality occurs, transitioning from the state of diagnosis being executed to the state of diagnosis unsuccessful, and terminating the state transition.

4. The sign diagnostic method according to claim 3, wherein the determining of the level of the mechanical abnormality of the AC electric motor (120) includes comparing a threshold value with the detected phase current and determining a level of an abnormality.

## Patentansprüche

1. Leistungsumsetzvorrichtung (110) zum Steuern eines Wechselstromelektromotors (120), wobei die Leistungsumsetzvorrichtung Folgendes umfasst:
eine Stromdetektionsschaltung (114) zum Detektieren eines Phasenstroms des Wechselstromelektromotors (120) und
eine Zeichendiagnosefunktionseinheit (116), die eine Zeichendiagnosefunktion zum Diagnostizieren eines Zeichens einer mechanischen Anomalie des Wechselstromelektromotors (120) aufweist, wobei die Zeichendiagnosefunktionseinheit (116) Folgendes enthält:
eine Diagnosebestimmungseinheit (201) zum Bestimmen eines Pegels einer mechanischen Anomalie des Wechselstromelektromotors (120) auf der Grundlage des detektierten Phasenstroms,
eine Diagnosemanagementeinheit (200) zum Management eines Ausführungszustands der Zeichendiagnosefunktion aus einem Bestimmungsergebnis der Diagnosebestimmungseinheit (201), einem Steuerzustand des Wechselstromelektromotors (120) und einem Umgebungszustand eines Fahrsystems, das den Wechselstromelektromotor (120) enthält, und
eine Ausgabeerzeugungseinheit (202) zum Erzeugen von Anzeigeinformationen eines Ausführungsergebnisses der Zeichendiagnosefunktion in Reaktion auf einen Befehl von der Diagnosemanagementeinheit (200) und zum Ausgeben der Anzeigeinformationen zu einer Außenseite der Leistungsumsetzvorrichtung (110), wobei
der Befehl von der Diagnosemanagementeinheit (200) ein Diagnoseergebnissignal (20B), das einem Anomaliegrad entspricht, und ein Diagnosemodussignal (20C), das einem Diagnosezustand entspricht, ist,
der Anomaliegrad ein vierstufiger Pegel unter nicht anwendbar, normal, anomales Zeichen und anomal ist,
der Diagnosezustand fünf Zustände von Diagnose ungültig, Diagnose wird vorbereitet, Diagnose wird ausgeführt, Diagnose ist unterbrochen und Diagnose nicht erfolgreich ist und
im Zustand Diagnose wird ausgeführt die Zeichendiagnosefunktionseinheit (116) bestimmt, ob eine Diagnoseanomalie auftritt oder nicht, und dann, wenn die Diagnoseanomalie auftritt, ein Übergang vom Zustand Diagnose wird ausgeführt zum Zustand Diagnose nicht erfolgreich vorgenommen wird und der Zustandsübergang beendet wird.

2. Leistungsumsetzvorrichtung (110) nach Anspruch 1, wobei die Diagnosebestimmungseinheit (201) einen Schwellenwert zur Anomaliebestimmung im Inneren aufweist und konfiguriert ist, den Schwellenwert mit dem Phasenstrom zu vergleichen, um einen Pegel einer Anomalie zu bestimmen.

3. Zeichendiagnoseverfahren zum Diagnostizieren eines Zeichens einer mechanischen Anomalie eines Wechselstromelektromotors (120) in einer Leistungsumsetzvorrichtung (110) zum Steuern des Wechselstromelektromotors (120), wobei das Verfahren Folgendes umfasst:
Detektieren eines Phasenstroms des Wechselstromelektromotors (120);
Bestimmen eines Pegels einer mechanischen Anomalie des Wechselstromelektromotors (120) auf der Grundlage des detektierten Phasenstroms;
Erzeugen eines Diagnoseergebnissignals (20B), das einem Anomaliegrad entspricht, und eines Diagnosemodussignals (20C), das einem Diagnosezustand entspricht, aus einem Bestimmungsergebnis, einem Steuerzustand des Wechselstromelektromotors (120) und einem Umgebungszustand eines Fahrsystems, das den Wechselstromelektromotor (120) enthält, wobei
der Anomaliegrad ein vierstufiger Pegel unter nicht anwendbar, normal, anomales Zeichen und anomal ist und der Diagnosezustand fünf Zustände von Diagnose ungültig, Diagnose wird vorbereitet, Diagnose wird ausgeführt, Diagnose ist unterbrochen und Diagnose nicht erfolgreich ist;
Erzeugen von Anzeigeinformationen aus dem Diagnoseergebnissignal (20B) und dem Diagnosemodussignal (20C);
Ausgeben der Anzeigeinformationen zu einer Außenseite der Leistungsumsetzvorrichtung (110) und
Bestimmen im Zustand Diagnose wird ausgeführt, ob eine Diagnoseanomalie auftritt oder nicht, und dann, wenn die Diagnoseanomalie auftritt, Übergehen vom Zustand Diagnose wird ausgeführt zum Zustand Diagnose nicht erfolgreich und Beenden des Zustandsübergangs.

4. Zeichendiagnoseverfahren nach Anspruch 3, wobei das Bestimmen des Pegels der mechanischen Anomalie des Wechselstromelektromotors (120) ein Vergleichen eines Schwellenwerts mit dem detektierten Phasenstrom und ein Bestimmen eines Pegels einer Anomalie umfasst.

## Revendications

1. Dispositif de conversion de puissance (110) destiné à commander un moteur électrique CA (120), le dispositif de conversion de puissance comprenant :
un circuit de détection de courant (114) destiné à détecter un courant de phase du moteur électrique CA (120) ; et
une unité à fonction de diagnostic de signe (116) ayant une fonction de diagnostic de signe destinée à diagnostiquer un signe d'anomalie mécanique du moteur électrique CA (120), l'unité à fonction de diagnostic de signe (116) incluant
une unité de détermination de diagnostic (201) destinée à déterminer un niveau d'anomalie mécanique du moteur électrique CA (120) sur la base du courant de phase détecté,
une unité de gestion de diagnostic (201) destinée à gérer un état d'exécution de la fonction de diagnostic de signe à partir d'un résultat de détermination de l'unité de détermination de diagnostic (201), un état de commande du moteur électrique CA (120), et un état d'environnement d'un système d'entraînement incluant le moteur électrique CA (120), et
une unité de génération de sortie (202) destinée à générer des informations d'affichage d'un résultat d'exécution de la fonction de diagnostic de signe en réponse à une instruction provenant de l'unité de gestion de diagnostic (200), et destinée à sortir les informations d'affichage vers l'extérieur du dispositif de conversion de puissance (110), dans lequel
l'instruction provenant de l'unité de gestion de diagnostic (200) est un signal de résultat de diagnostic (20B) correspondant à un degré d'anomalie et un signal de mode de diagnostic (20C) correspondant à un état de diagnostic, dans lequel
le degré d'anomalie est un niveau à quatre paliers parmi non applicable, normal, signe anormal, et anormal, dans lequel
l'état de diagnostic est cinq états parmi invalidité de diagnostic, diagnostic en préparation, diagnostic en exécution, diagnostic en pause, et diagnostic sans succès, dans lequel
dans l'état de diagnostic en exécution, l'unité à fonction de diagnostic de signe (116) détermine si oui ou non une anomalie de diagnostic se produit, et quand l'anomalie de diagnostic se produit, une transition est réalisée de l'état de diagnostic en exécution à l'état de diagnostic sans succès, et la transition d'état est terminée.

2. Dispositif de conversion de puissance (110) selon la revendication 1, dans lequel l'unité de détermination de diagnostic (201) a une valeur seuil pour une détermination d'anomalie à l'intérieur, et est configurée pour comparer la valeur seuil au courant de phase pour déterminer un niveau d'anomalie.

3. Procédé de diagnostic de signe pour diagnostiquer un signe d'anomalie mécanique d'un moteur électrique CA (120) dans un dispositif de conversion de puissance (110) destiné à commander le moteur électrique CA (120), le procédé comprenant les étapes consistant à :
détecter un courant de phase du moteur électrique CA (120) ;
déterminer un niveau d'anomalie mécanique du moteur électrique CA (120) sur la base du courant de phase détecté ;
générer un signal de résultat de diagnostic (20B) correspondant à un degré d'anomalie et un signal de mode de diagnostic (20C) correspondant à un état de diagnostic provenant d'un résultat de détermination, un état de commande du moteur électrique CA (120), et un état d'environnement d'un système d'entraînement incluant le moteur électrique CA (120), dans lequel le degré d'anomalie est un niveau à quatre paliers parmi non applicable, normal, signe anormal, et anormal, et l'état de diagnostic est cinq états parmi invalidité de diagnostic, diagnostic en préparation, diagnostic en exécution, diagnostic en pause, et diagnostic sans succès ;
générer des informations d'affichage à partir du signal de résultat de diagnostic (20B) et du signal de mode de diagnostic (20C) ; et
sortir les informations d'affichage vers l'extérieur du dispositif de conversion de puissance (110), et
déterminer, dans l'état de diagnostic en exécution, si oui ou non une anomalie de diagnostic se produit, et quand l'anomalie de diagnostic se produit, faire une transition de l'état de diagnostic en exécution à l'état de diagnostic sans succès, et terminer la transition d'état.

4. Procédé de diagnostic de signe selon la revendication 3, dans lequel l'étape consistant à déterminer le niveau d'anomalie mécanique du moteur électrique CA (120) inclut de comparer une valeur seuil au courant de phase détecté et de déterminer un niveau d'anomalie.
